# EUROPÄISCHE PATENTANMELDUNG

(11) **EP 0 997 859 A2**
(43) Veröffentlichungstag der Anmeldung: **03.05.2000**
(21) Anmeldenummer: 99121290.3
(22) Anmeldetag: 26.10.1999
(51) Int. Cl.: G08B 13/183, F16P 3/14, G01V 8/20

(54) **Lichtschrankensteuergerät**

(30) Priorität: 27.10.1998 DE 19849502
(71) Anmelder: WERAC Elektronik GmbH, 76744 Wörth (DE)
(72) Erfinder: Lexe, Werner, 76744 Wörth (DE); Eichhorn, Ronald, 76185 Karlsruhe (DE)
(74) Vertreter: Pfeifer, Hans-Peter, Dr., Dr. H.-P. Pfeifer Dr. P. Jany, Patentanwälte

(57) **Zusammenfassung**

Lichtschrankensteuergerät für mehrere Lichtschranken, die jeweils einen Lichtsender und einen Lichtempfänger aufweisen, mit einer Elektronikeinheit (15) an der die Signale der Lichtschranken anliegen und die ein Sicherheitssignal erzeugt, wenn mindestens eine Lichtschranke unterbrochen wird, wobei die Elektronikeinheit ein ROM-Schrittschaltwerk (8) enthält.

Erfindungsgemäß enthält die Elektronikeinheit zwei ROM-Schrittschaltwerke (8A, 8B) mit jeweils einem ROM (11A, 11B) und einen nachgeordneten Schrittspeicher (12A, 12B) enthält, jedes ROM Empfängereingänge (A7-A10) aufweist, an das Empfängersignale anliegen, die beiden ROM-Schrittschaltwerke (8A, 8B) synchron getaktet sind und die Nutzsignalausgänge (Q7) beider Schrittschaltwerke (8A, 8B) mit einer gemeinsamen Sicherheitssignal-Erzeugungseinrichtung (10) verbunden sind, die ein Sicherheitssignal erzeugt, wenn an dem Nutzsignalausgang (Q7) von mindestens einem der Schrittschaltwerke (8A, 8B) ein Störfall-Ausgangssignal erzeugt wird.

## Beschreibung

Die Erfindung betrifft eine Lichtschrankensteuergerät für mehrere Lichtschranken, die jeweils einen Lichtsender und einen Lichtempfänger aufweisen. Das Steuergerät steuert die Lichtsender an, fragt die Signale der Lichtempfänger ab und erzeugt ein Sicherheitssignal, wenn mindestens eine Lichtschranke unterbrochen wird.

Lichtschrankensteuergeräte werden vor allem im Maschinenbau vielfach eingesetzt, um Gefahren durch unbeabsichtigtes Eindringen von Körperteilen des Bedienungspersonals oder auch von Gegenständen in Risikozonen innerhalb der Maschine zu vermeiden. In der Regel ist eine einzige Lichtschranke nicht ausreichend, sondern die Risikozone wird mit einer Mehrzahl von Lichtschranken geschützt, die häufig zu Lichtvorhängen zusammengefaßt sind, welche aus vielen übereinander angeordneten Lichtschranken bestehen. Das von einer Elektronikeinheit des Steuergerätes erzeugte Sicherheitssignal dient meist zur Betätigung eines Schütz, welcher die Maschine stillsetzt. Es kann jedoch auch zur Ansteuerung anderer Sicherheitsfunktionen dienen, beispielsweise zum Einschalten eines akustischen Warnsignals oder einer automatischen Absperrung der Risikozone.

Wegen der hohen Bedeutung der Funktionssicherheit von Lichtschrankensteuergeräten wird für deren Funktion ein außerordentlich hoher Sicherheitstandard verlangt. Die Elektronikeinheit des Steuergerätes, die die Lichtschranken ansteuert und aus dem Empfängersignalen ein Sicherheitssignal erzeugt, enthält deshalb üblicherweise eine Vielzahl von Überprüfungsfunktionen, mit denen die Elemente der Lichtschranken ebenso wie die Elektronikeinheit selbst laufend auf korrekte Funktion geprüft werden. Hierzu werden üblicherweise Mikrocomputer eingesetzt, die mittels aufwendiger Programme die verschiedenen Funktionen der Sicherheitseinrichtung überwachen (DE 3790010 T1). Risiken durch Fehler in den Mikrocomputern selbst können dabei nur dadurch eliminiert werden, daß mindestens zwei unabhängige Mikrocomputer eingesetzt werden, die sich gegenseitig überprüfen.

Die vorliegende Erfindung betrifft einen speziellen Typ eines Lichtschrankensteuergerätes, bei dem die Elektronikeinheit nicht auf der Mikroprozessortechnik basiert, sondern ein ROM-Schrittschaltwerk aufweist. Das ROM-Schrittschaltwerk enthält ein ROM und einen dem ROM nachgeordneten Schrittspeicher mit mindestens N bistabilen Speicherstellen sowie einen Taktgenerator zur Taktung des Schrittspeichers. Mindestens ein Teil N der Ausgänge des ROM, der als Rückführungsausgänge bezeichnet wird, liegt an N Rückführungseingängen des Schrittspeichers an. Die entsprechenden N Rückführungsausgänge des Schrittspeichers sind auf N Rückführungseingänge des ROM zurückgeführt. Dadurch bildet das jeweils an den Rückführungsausgängen des Schrittspeichers anliegende N-Bit-Wort einen Teil der am Eingang des ROM anliegende Adresse, also eine erste Teiladresse des ROM. Das jeweils an den Rückführungsausgängen des ROM anliegende N-Bit-Wort bildet nach Taktung des Schrittspeichers die nächstfolgende Teiladresse. Infolgedessen läuft in dem ROM-Schrittschaltwerk eine weitgehend (nämlich hinsichtlich der ersten Teiladresse) durch den Speicherinhalt des ROM vorbestimmte Schrittfolge ab, solange der Schrittspeicher Taktsignale von dem Taktgenerator erhält. Mindestens ein Teil M der Ausgänge des Schrittspeichers dient als Ansteuerungsausgänge zum Ansteuern der Lichtsender. Die Ausgangssignale der Empfänger liegen an weiteren Eingängen des ROM an, die als Empfängereingänge bezeichnet werden und bilden somit eine zweite Teiladresse des ROM. Mindestens einer der Ausgänge des Schrittspeichers dient als Nutzsignalausgang, der mit einer Sicherheitssignal-Erzeugungseinrichtung verbunden ist. Die Gesamtadresse, die aus erster und zweiter Teiladresse gebildet wird, adressiert Speicherstellen des ROM, für die folgende Bedingungen gelten:
a) Für den Fall, daß die zweite Teiladresse einer funktionierenden ununterbrochenen Lichtschranke entspricht (Normalbetriebsfall) enthalten die durch die Gesamtadresse adressierten Speicherstellen eine vorbestimmte Folge von Bit-Mustern, bei der sich die an den Ausgängen des ROM anliegenden N-Bit-Worte zyklisch wiederholen, so daß sich die Schrittfolge des ROM-Schrittschaltwerkes ebenfalls zyklisch wiederholt. Während dieses Zyklus, der als Normalbetriebszyklus bezeichnet wird, werden die Lichtschranken über die Ansteuerungsausgänge zyklisch angesteuert. An dem Nutzsignalausgang des ROM-Schrittschaltwerkes wird eine vorbestimmte Folge von digitalen Impulsen generiert, die als Normalbetriebs-Ausgangssequenz bezeichnet wird.
b) Für den Fall, daß die zweite Teiladresse nicht einer ununterbrochenen Lichtschranke entspricht, enthalten die von der Gesamtadresse adressierten Speicherstellen des ROM ein von der vorbestimmten Folge der Bit-Muster des Normalbetriebszyklus abweichenden Speicherinhalt. In diesem Fall wird der Normalbetriebszyklus verlassen und an dem Nutzsignalausgang ein Störfall-Ausgangssignal erzeugt, aufgrund dessen die Sicherheitssignal-Erzeugungseinrichtung das Sicherheitssignal erzeugt.

Ein solches Lichtschrankensteuergerät ist aus der EP 0371317 A2 bekannt. Es zeichnet sich dadurch aus, daß ein hoher Sicherheitsstandard mit geringem baulichen Aufwand erreicht wird. Um auch durch interne Fehler in den Bausteinen des ROM-Schrittschaltwerkes verursachte Risiken weitgehend auszuschließen, wird in der Vorpublikation vorgeschlagen, jeden Lichtschranken-Empfänger parallel an zwei Eingänge des ROM anzuschließen und einen Teil der Ausgänge des ROM als Kontrollausgänge zu verwenden, die zu den Rückführungsausgängen gehören. Dabei ist der Speicherinhalt des ROM bezüglich der Kontrollausgänge so gewählt, daß sich alle N-Bit-Worte an den Rückführungseingängen jeweils in mindestens zwei Bit voneinander unterscheiden.

Auf der Grundlage dieses Standes der Technik liegt der Erfindung die Aufgabe zugrunde, ein Lichtschrankensteuergerät zur Verfügung zu stellen, das ohne wesentliche Erhöhung des baulichen Aufwandes die Ansteuerung und Abfrage einer größeren Anzahl von Lichtschranken ermöglicht.

Die Aufgabe wird bei einem Lichtschrankensteuergerät mit ROM-Schrittschaltwerk der vorstehend erläuterten Art dadurch gelöst, daß die Elektronikeinheit zwei ROM-Schrittschaltwerke mit jeweils einem ROM und einem nachgeordneten Schrittspeicher enthält, jedes ROM Empfängereingänge aufweist, an denen Empfängersignale anliegen, die beiden ROM-Schrittschaltwerke synchron getaktet sind und die Nutzsignalausgänge beider Schrittschaltwerke mit einer gemeinsamen Sicherheitssignal-Erzeugungseinrichtung verbunden sind, die ein Sicherheitssignal erzeugt, wenn an dem Nutzsignalausgang von mindestens einem der Schrittschaltwerke ein Störfall-Ausgangssignal erzeugt wird.

Im Rahmen der Erfindung wurde überraschenderweise festgestellt, daß der durch die Integration von zwei ROM-Schrittschaltwerken in der Elektronikeinheit verursachte zusätzliche bauliche Aufwand weitgehend durch Einsparungen an anderer Stelle kompensiert werden kann. Ohne Vergrößerung der für das ROM und den Schrittspeicher verwendete elektronischen Bauelemente kann eine größere Zahl von Lichtschranken angesteuert und abgefragt werden. Zugleich werden zusätzliche Sicherheitsfunktionen möglich, die auch höchsten Anforderungen gerecht werden.

Dies gilt in besonderem Maße für bevorzugte Ausführungsformen, die Gegenstand von Unteransprüchen sind und nachfolgend näher erläutert werden. Die darin beschriebenen Merkmale können einzeln oder in Kombination in Verbindung mit den Merkmalen des Hauptanspruchs eingesetzt werden.

Die Erfindung wird im folgenden anhand von in den Figuren schematisch dargestellten Ausführungsbeispielen näher erläutert. Es zeigen:
- Fig. 1: Ein Blockschaltbild von einer Lichtschranken-Sicherheitseinrichtung mit einem Steuergerät mit Schrittschaltwerk nach dem Stand der Technik.
- Fig. 2: Eine Schrittfolge-Tabelle zur Erläuterung der Funktion des Steuergerätes nach Figur 1
- Fig. 3: Ein Blockschaltbild der Elektronikeinheit eines erfindungsgemäßen Steuergerätes
- Fig. 4 und Fig. 5: Schrittfolge-Tabellen zur Erläuterung der Funktion der Elektronikeinheit gemäß Fig. 3.
- Fig. 6: Ein Impulsdiagramm verschiedener Impuls-Sequenzen der Elektronikeinheit gemäß Fig. 3.

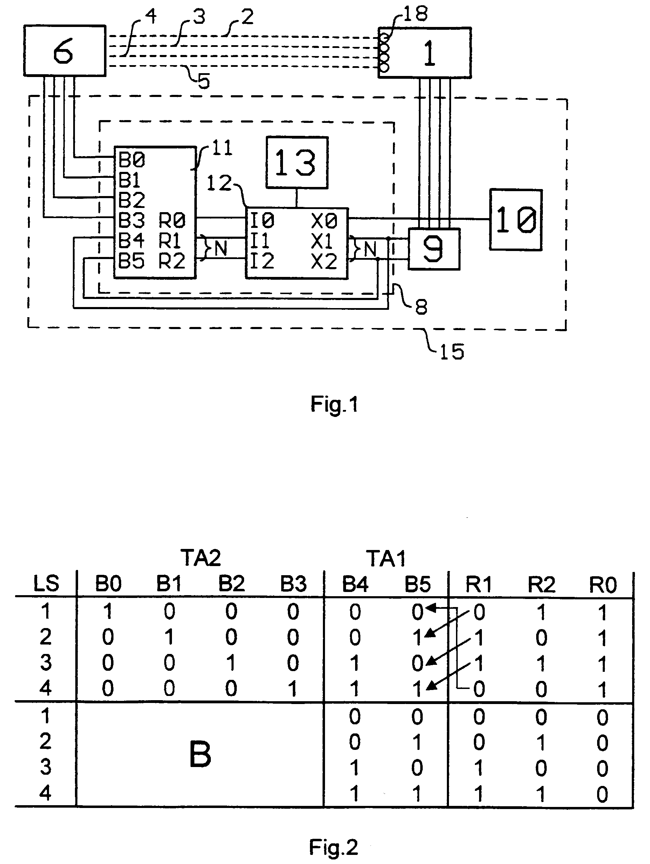

Die Figuren 1 und 2 dienen dazu, das Prinzip eines Lichtschrankensteuergerätes mit einer Elektronikeinheit auf Basis eines ROM-Schrittschaltwerkes anhand eines einfachen Beispiels zu erläutern.

Eine Sendereinheit 1 sendet vier Lichtstrahlen 2 bis 5 an eine Empfängereinheit 6. Zu diesem Zweck enthält die Sendereinheit vier Lichtsender und die Empfängereinheit vier Empfänger mit zugehöriger elektronischer Schaltung. Die vier Lichtschranken 2 bis 5 können beispielsweise einen Lichtvorhang zur Absicherung einer Risikozone in einer Maschine bilden.

Zur Ansteuerung der Lichtsender, zur Abfrage der Empfänger und zur Erzeugung eines Sicherheitssignals für den Fall, daß mindestens eine der Lichtschranken unterbrochen wird, dient die Elektronikeinheit 15 eines Steuergerätes. Sie umfaßt ein insgesamt mit 8 bezeichnetes ROM-Schrittschaltwerk, einen Decoder 9 und eine Sicherheitssignal-Erzeugungseinrichtung 10. Das ROM-Schrittschaltwerk besteht aus einem ROM 11, einem gemäß seiner Funktion als Schrittspeicher bezeichneten Speicherbaustein 12 mit mehreren bistabilen Speicherelementen (Flip-Flops) und einem Taktgenerator 13.

Das ROM 11 enthält eine Vielzahl von Speicherstellen, die über Adressierungseingänge B0 bis B5 angesteuert werden. Der Speicherinhalt der jeweils angesteuerten Speicherstelle liegt an den Ausgängen R0 bis R2 an. In der Praxis wird das ROM 11 mit Hilfe eines Standard-EPROM-Bausteins kostengünstig realisiert.

Die Ausgänge R0 bis R2 des ROM 11 sind mit entsprechenden Eingängen I0 bis I2 des Schrittspeichers 12 verbunden. An den Ausgängen X0 bis X2 des Schrittspeichers stehen jeweils nach einem Takt des Taktgenerators 13 die vor dem Takt an dessen Eingängen anliegenden digitalen Zustände an. Ein Teil N der Ausgänge des Schrittspeichers 12 ist auf Eingänge B4, B5 des ROM zurückgeführt. Die Eingänge B4, B5 und I1, I2 bzw. die Ausgänge R1, R2 und X1, X2 werden als Rückführungseingänge bzw. Rückführungsausgänge der entsprechenden Bauteile bezeichnet.

Die Rückführungsausgänge X1, X2 des Schrittspeichers 12 sind zugleich mit dem Decoder 9 verbunden, der aus den an seinen Eingängen anliegenden Bit-Mustern Ansteuerungssignale für die Sendereinheit 1 erzeugt. Alternativ können auch von den Rückführungseingängen unabhängige Ausgänge des ROM-Schrittschaltwerkes 8 zur Ansteuerung der Lichtschranken verwendet werden.

Das ROM 11 weist weiterhin einen Nutzsignalausgang R0 auf, der mit einem Nutzsignaleingang I0 des Schrittspeicher 12 verbunden ist. Der zugeordnete Nutzsignalausgang X0 ist mit der Sicherheitssignal-Erzeugungseinrichtung 10 verbunden.

Die Ausgänge der vier in der Empfängereinheit 6 zusammengefaßten Lichtempfänger sind an die Eingänge B0 bis B3 des ROM 11 angeschlossen. Die jeweilige Speicheradresse des ROM 11 umfaßt demzufolge eine erste Teiladresse TA1 (Figur 2), die durch die Ausgangssignale der Rückführungsausgänge X1, X2 des Schrittspeichers 12 gebildet wird und eine zweite Teiladresse TA2, die aus den Ausgangssignalen der Empfänger der Lichtschranken 2 bis 5 besteht.

In Figur 2 sind zur Erläuterung der Funktion beispielhaft die Zustände der verschiedenen Eingänge und Ausgänge des ROM für die einzelnen Schritte einer mit Hilfe des ROM-Schrittschaltwerkes von Figur 1 ablaufenden Schrittfolge dargestellt.

Die vier ersten Zeilen der Schrittfolge-Tabelle zeigen die Zustände im Normalbetrieb, d.h. bei freier Lichtschranke. Der an den Ausgängen R0 bis R2 jeweils anliegende Speicherinhalt der durch die Eingangssignale der ROM adressierten Speicherstelle wird bei der Herstellung des Gerätes festgelegt.

Die Schrittfolge und die Ansteuerung der Lichtsender der Lichtschranken LS im Normalbetriebszyklus wird durch die an den Rückführungsausgängen R1, R2 anliegenden N-Bit-Worte bestimmt, die sich zyklisch wiederholen. Im dargestellten Fall sind es die vier möglichen Zustände eines 2-Bit-Wortes, d.h. die Zahl der angesteuerten Lichtschranken entspricht der maximal möglichen Anzahl verschiedener Zustände an den Rückführungsausgängen. In jedem Fall ist die Bedingung eines sich zyklisch wiederholenden Bit-Musters dahingehend zu verstehen, daß keines der an den Rückführungseingängen im Normalbetriebszyklus der Schrittfolge anstehenden Bit-Muster doppelt vorkommt und daß jeweils das an den Rückführungsausgängen anliegende Bit-Muster diejenige erste Teiladresse TA1 des nächstfolgenden Schrittes bildet, die zusammen mit einer zweiten Teiladresse TA2, die einem ungestörten Zustand der jeweils angesteuerten Lichtschranke entspricht, diejenige Speicherstelle des ROM adressiert, in der die nächste erste Teiladresse des festliegenden Normalbetriebszyklus gespeichert ist.

In Figur 2 enthält die zweite Teiladresse TA2 jeweils für die angesteuerte Lichtschranke eine logische Eins und für die übrigen Lichtschranken eine Null. Die dadurch in Verbindung mit der jeweiligen ersten Teiladresse angesteuerten Speicherstellen enthalten die erste Teiladresse des nächsten Schrittes. Demzufolge stimmen die Ausgangssignale der Spalten R1 und R2 mit der nächsten Zeile der Eingangssignale der Spalten B4 und B5 überein.

Das ROM-Schrittschaltwerk durchläuft in dem Normalbetriebszyklus ständig die in Figur 2 in den ersten vier Zeilen dargestellten Zustände (Schritte) wobei bei jedem Takt des Taktgenerators 13 eine Umschaltung in die nächste Zeile erfolgt. Die Sender der Sendereinheit 1 werden somit zyklisch angesteuert. Die zyklische Schleife wird nicht unterbrochen, solange die Lichtschranken frei sind. Bezüglich des Nutzsignalausgangs R0 enthalten im dargestellten Beispiel sämtliche vier angesteuerten Speicherstellen des ROM eine logische Eins (nachfolgend auch mit "H" (high) bezeichnet), d.h. die Normalbetriebs-Ausgangssequenz wird aus einer Folge von H-Zuständen gebildet. Diese Normalbetriebs-Ausgangssequenz kann in für den Fachmann geläufiger Weise (beispielsweise, wie in der EP 0 371 317, mit Hilfe eines frequenzselektiven Ausgangsübertragers) in ein Ausgangssignal der Elektronikeinheit 15 umgesetzt werden, das den Normalbetrieb der angeschlossenen Maschine steuert. Es wird nachfolgend als Normalbetriebssignal der Elektronikeinheit bezeichnet. Insbesondere kann ein Relais angezogen werden, über das die von den Lichtschranken überwachte Maschine mit Strom versorgt wird.

Für jedes von dem Normalbetriebszyklus abweichende Bit-Muster (in Fig. 2 mit B bezeichnet) an den Eingängen B0 bis B5 enthält das ROM einen Speicherinhalt, auf den die Sicherheitssignal-Erzeugungseinrichtung 10, (beispielsweise mit Hilfe einer entsprechenden Decoder-Schaltung) dahingehend anspricht, daß sie ein Sicherheitssignal abgibt. Ein solches Bit-Muster wird als Störfall-Ausgangssignal des Schrittschaltwerkes bezeichnet. Im dargestellten Fall wird es durch den Nutzsignalausgang R0 bestimmt. Er enthält für alle Speicherstellen, die nicht von dem Normalbetriebszyklus angesteuert werden, eine logische Null, die von der Sicherheitssignal-Erzeugungseinrichtung in ein entsprechendes Sicherheitssignal der Elektronikeinheit umgewandelt wird.

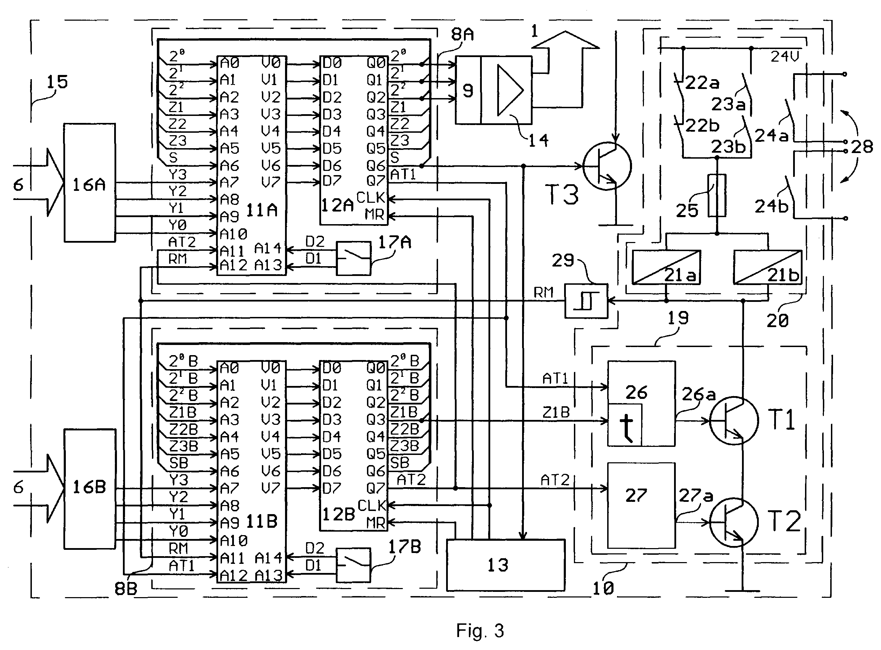

Das in den Figuren 1 und 2 dargestellte bisher beschriebene ROM-Schrittschaltwerk entspricht dem Stand der Technik gemäß der EP 0 371 317 A1. Demgegenüber besteht eine wesentliche Besonderheit der in Figur 3 dargestellten Elektronikeinheit 15 eines erfindungsgemäßen Steuergerätes darin, daß es zwei ROM-Schrittschaltwerke 8A und 8B mit jeweils einem ROM 11A bzw. 11B und jeweils einem Schrittspeicher 12A und 12B aufweist. Die Abfrage der Lichtschranken wird von beiden Schrittschaltwerken durchgeführt.

Nur eines der Schrittschaltwerke, nämlich das Schrittschaltwerk 8A, steuert über einen Teil seiner Ausgänge Q0 bis Q2, einen Decoder 9 und eine Treiberstufe 14 die Sender in der Sendereinheit 1 an. Ein weiterer Bestandteil der Senderansteuerung ist der Ausgang Q6 des Schrittschaltwerkes 8A, der über ein Schaltverstärkerelement, wie beispielsweise den dargestellten Schalttransistor T3 die Stromzufuhr zu der Sendereinheit steuert, um die nachfolgend noch erläuterte Senderaktivierung zu ermöglichen.

Beide Schrittschaltwerke werden von einem gemeinsamen Taktgenerator 13 getaktet. Er erzeugt sowohl (insbesondere beim Einschalten des Gerätes) Reset-Signale für die Reset-Eingänge MR der beiden Schrittspeicher 12A und 12B als auch einen Takt, der an die Takteingänge CLK der Schrittspeicher 12A und 12B angelegt ist. Außerdem wird dem Taktgenerator das Signal S des Ausgangs Q6 des Schrittschaltwerkes 8A zugeführt.

Die ROM-Bausteine sind im dargestellten Fall 32 K x 8 EPROM mit 15 Eingängen und 8 Ausgängen. Die Schrittspeicher-Bausteine 12 sind 8 x D-Flipp-Flopp. Die im Vergleich zu Figur 1 größere Anzahl von Ausgängen ermöglicht die unabhängige Ansteuerung und Abfrage einer größeren Anzahl von Lichtschranken, wobei im dargestellten Fall mit den drei Ausgängen Q0 bis Q2 acht Lichtschranken unabhängig angesteuert werden können.

Von den acht Ausgängen der ROM 11A und 11B sind jeweils sieben, nämlich die Ausgänge V0 bis V6, Rückführungsausgänge, die an entsprechende Rückführungseingänge D0 bis D6 der Schrittspeicher 12A, 12B angeschlossen sind. Infolgedessen liegen ihre Bit-Muster jeweils beim Folgeschritt an den entsprechenden Eingängen, nämlich den Eingängen A0 bis A6 des ROM an. Der einzige nicht rückgeführte Ausgang des ROM ist der Nutzsignalausgang V7, dessen Ausgangssignal jeweils nach dem nächsten Takt an dem Nutzsignalausgang Q7 der Schrittspeicher 12A und 12B anliegt. Die Ausgänge Q7 der Schrittspeicher 12A und 12B bilden die Ausgänge der Schrittschaltwerke 8A und 8B, deren Signale der Sicherheitssignal-Erzeugungseinrichtung 10 zugeführt werden.

Jeweils vier Eingänge A7 bis A10 der beiden ROM 11A und 11B dienen als Empfängereingänge, an die Signale der Empfängereinheit 6 anliegen, wobei im dargestellten Fall die Signale der Empfänger nicht unmittelbar, sondern über einen Encoder 16A bzw. 16B indirekt zugeführt werden. Dadurch kann die Anzahl der abgefragten Empfänger größer als die Anzahl der zur Verfügung stehenden Eingänge sein. Im dargestellten Fall ermöglichen die vier Eingänge 2⁴ digitale Zustände, so daß 8 Lichtschrankenempfänger (mit je zwei möglichen Zuständen) unabhängig abgefragt werden können.

Weiterhin hat jedes der ROM 11A und 11B einen Rückmeldungseingang A11, an dem ein aus der Sicherheitssignal-Erzeugungseinrichtung 10 herausgeführtes Rückmeldungssignal RM anliegt, um während des Normalbetriebszyklus eine Überprüfung der darin enthaltenen Schalttransistoren T1, T2 auf Kurzschluß zu ermöglichen, wie weiter unten erläutert wird.

Die beiden Schrittschahtwerke 8A und 8B werden synchron getaktet. Dadurch, daß nur eines der Schrittschaltwerke die Lichtschranken ansteuert, die Empfängersignale jedoch beiden Schrittschaltwerken zugeführt werden, führt jede Abweichung von dem synchronen Lauf zur Erzeugung eines Sicherheitssignales. Zur zusätzlichen Überprüfung des synchronen Laufes und der Funktion des jeweils anderen Schrittschaltwerkes weist jedes ROM 11A und 11B einen Eingang A12 auf, der mit dem Nutzsignalausgang Q7 des anderen Schrittschaltwerkes verbunden ist, so daß das Ausgangssignal AT1 des Schrittschaltwerkes 8A an dem Eingang A12 des ROM 11B und umgekehrt das Ausgangssignal AT2 des Schrittschaltwerkes 8B an dem Eingang A12 des ROM 11A anliegt. Da die Eingänge A12 dazu dienen, die Funktion des jeweils anderen (Partner-)Schrittschaltwerkes zu überwachen, werden sie als Partnerüberwachungseingänge bezeichnet.

Schließlich weist jedes ROM Einstelleingänge A13 und A14 auf, an die individuell einstellbare Schalter (beispielsweise DIP-Schalter) 17A und 17B angeschlossen sind, um die Einstellung verschiedener Betriebszustände des Steuergerätes zu ermöglichen, die sich hinsichtlich der Anzahl der Lichtschranken unterscheiden.

Die an den Nutzsignalausgängen Q7 der beiden Schrittschaltwerke 8A und 8B anstehenden Ausgangssignale bestehen im Betrieb der Steuereinheit aus einer Folge digitaler Zustände. Um hieraus (aus Gründen, die noch erläutert werden) Impulse von vorbestimmter Dauer zu generieren, werden die Ausgangssignale AT1 und AT2 jeweils einem monostabilen Multivibrator (Monoflopp) zugeführt, der von Flanken der digitalen Zustände getriggert wird und an dem jeweiligen Ausgang 26a und 27a jeweils einen Impuls erzeugt, dessen Dauer der Laufzeit des jeweiligen Monoflopps entspricht. Die Ausgangssignale der Monoflopps 26 und 27 liegen am Eingang von jeweils einem Schalttransistor T1 bzw. T2 an. Statt der dargestellten bipolaren Transistoren T1 und T2 können selbstverständlich auch andere Schaltelemente (beispielsweise Darlington- oder MOS-Transistoren) verwendet werden.

Die beiden Schalttransistoren T1 und T2 sind in Reihe geschaltet, so daß ein Stromfluß durch die Reihenschaltung nur möglich ist, wenn beide Transistoren leitend sind. Die Transistoren T1 und T2 (oder andere Schaltelemente) bilden somit (bevorzugt, wie dargestellt, in Verbindung mit vorgeschalteten Monoflopps) eine Verknüpfungsschaltung 19, durch die die beiden Ausgangssignale der Schrittschaltwerke 8A und 8B im Sinne einer logischen "und"-Verknüpfung dergestalt verknüpft werden, daß ein Ausgangssignal, welches funktionierenden und freien Lichtschranken entspricht (Normalbetriebssignal), nur erzeugt werden kann, wenn beide Schrittschaltwerke 8A und 8B eine Normalbetriebsausgangssequenz erzeugen. Andernfalls wird ein Sicherheitssignal abgegeben. Das Ausgangssignal der Verknüpfungsschaltung 19 ist über einen Schmitt-Trigger 29 an die Rückführungseingänge A11 der ROM 11A und 11B angeschlossen.

Die Steuereinheit enthält eine Relais-Einheit 20. Sie besteht im dargestellten Fall aus zwei zwangsgeführten Relais, deren Bestandteile mit den Buchstaben a und b gekennzeichnet sind. Die Relais-Spulen 21a und 21b sind parallel geschaltet und betätigen die Arbeitskontakte 22a, 23a und 24a beziehungsweise 22b, 23b und 24b. Durch die dargestellte Äquivalenzschaltung der Kontakte 22a, 23a, 22b, 23b in der Stromversorgung der Relais-Spulen 21a und 21b wird erreicht, daß im Falle des Hängenbleibens eines der Relais das andere keine Spannung mehr bekommt und deswegen eine Fehlfunktion durch ein solches Hängenbleiben verhindert wird. Diese Gestaltung der Relais-Einheit 20 ist besonders vorteilhaft, jedoch können auch andere vorbekannte Relais-Einheiten von der Verknüpfungsschaltung 19 angesteuert werden.

Der Ausgang 28 des Steuergerätes wird bei der dargestellten Ausführungsform von den Arbeitskontakten 24a und 24b der Relais a und b gebildet. An den Ausgang 28 wird in üblicher Weise eine Nachfolgeschaltung angeschlossen, die in der Regel einen Motorschütz der von dem Lichtschrankensteuergerät geschützten Maschine betätigt. Daneben übernimmt die Nachfolgeschaltung in üblicher Weise weitere Funktionen (Anlauf- und Wiederanlaufsperre; Anlauftestung). Eine nähere Beschreibung ist nicht erforderlich, da diese Elemente von dem erfindungsgemäßen Lichtschrankensteuergerät in gleicher Weise wie von konventionellen Lichtschrankensteuergeräten angesteuert werden.

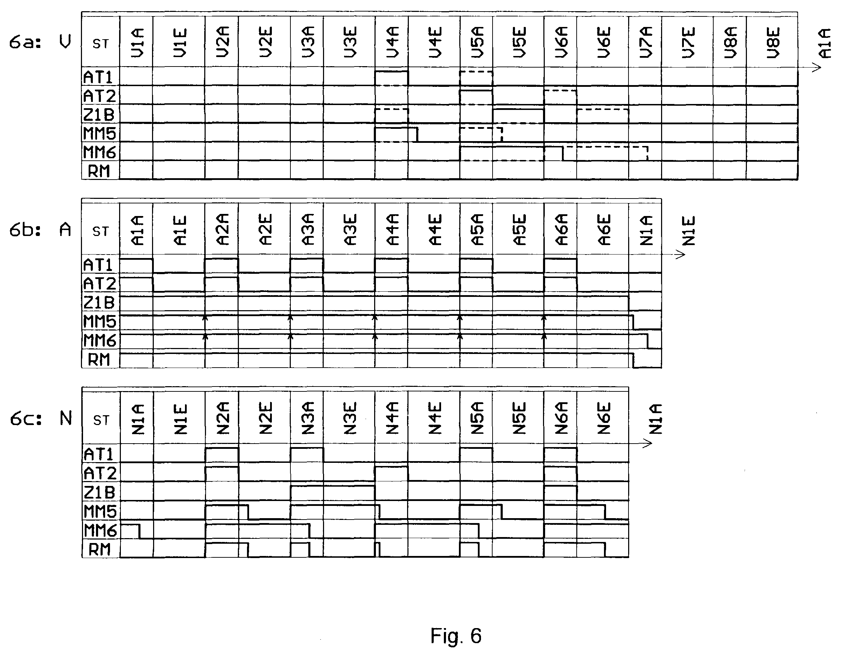

Eine Sicherung 25 ist im dargestellten Fall in der Relaiseinheit 20 angeordnet. Sie kann auch an einer anderen Stelle in dem von den Transistoren T1 und T2 geschalteten Strompfad vorgesehen sein. Die Transistoren T1 und T2 werden, wie weiter unten anhand von Figur 6 noch näher erläutert wird, in dem Normalbetriebszyklus vorzugsweise derartig angesteuert, daß nur während eines kleinen Teiles des Normalbetriebszyklus beide Transistoren leitend sind und demzufolge ein Strom fließt. Die Zeit, in der beide Schalter geschlossen (d.h. beide Transistoren leitend) sind, wird hier als Schließzeit bezeichnet. Der Anteil der Schließzeit an der Gesamtdauer des Normalbetriebszyklus beträgt weniger als 50%, bevorzugt weniger als 30%. Durch diese kurze Schließzeit resultiert ein entsprechend reduzierter Stromfluß durch die Sicherung 25. Der Grenzwert der Sicherung ist so ausgelegt, daß sie bei Überschreiten der vorgesehenen Schließzeit anspricht. Dies geschieht insbesondere, wenn einer der Transistoren durch Kurzschluß oder einen anderen Fehler ständig leitend wird. Durch diese bevorzugte Maßnahme wird demgemäß eine erhöhte Sicherheit bezüglich entsprechender Fehler der Transistoren oder deren Ansteuerung erreicht.

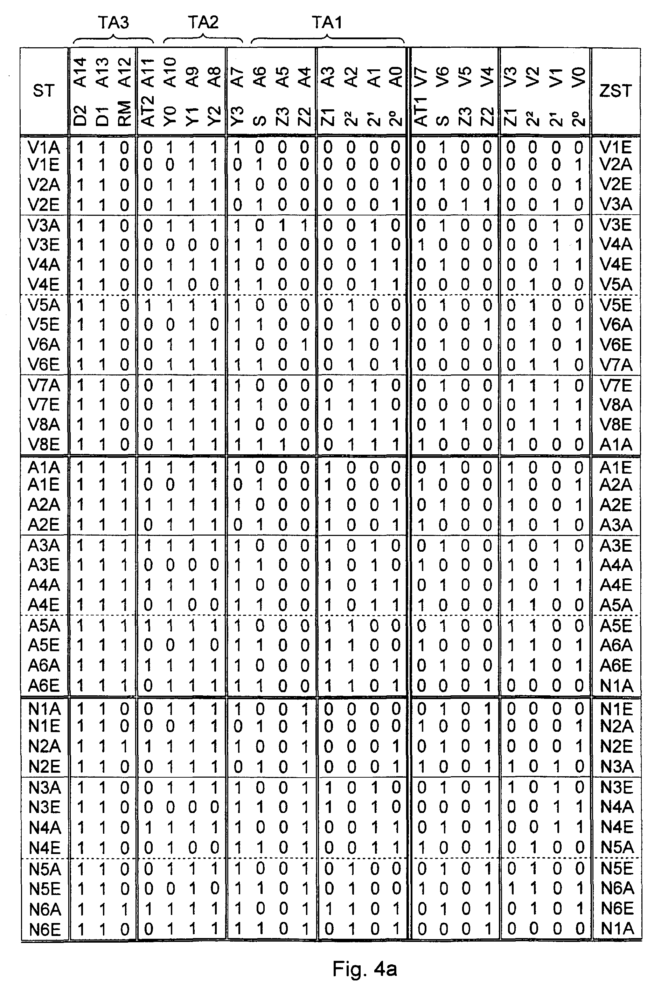

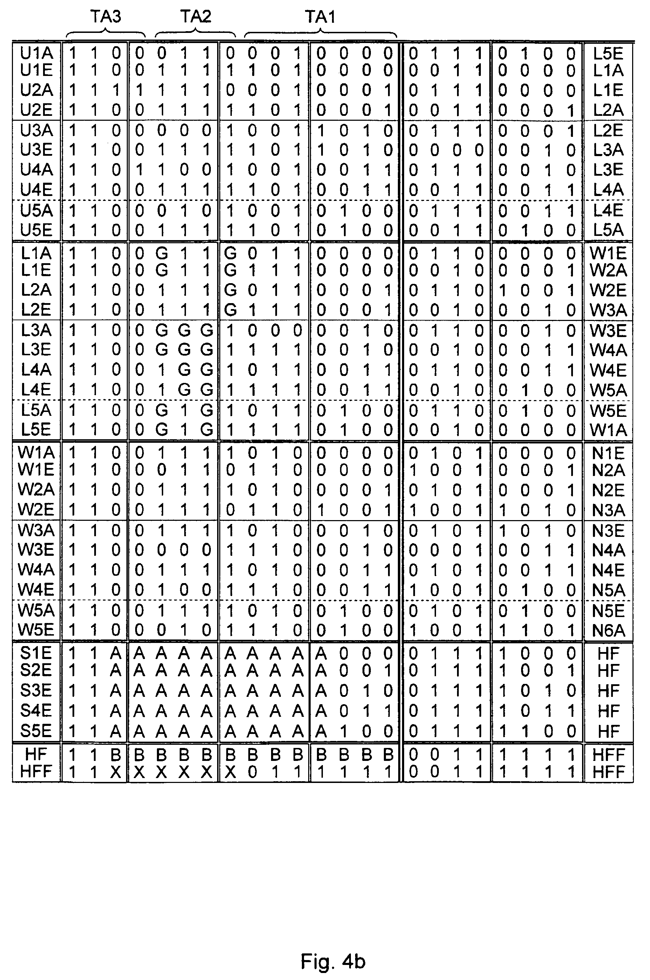

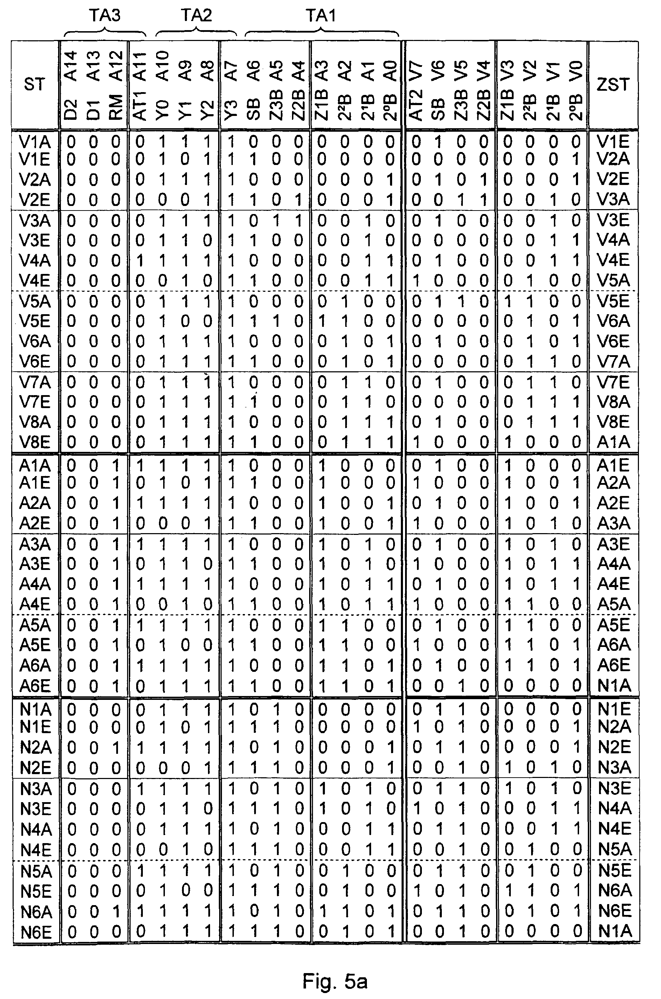

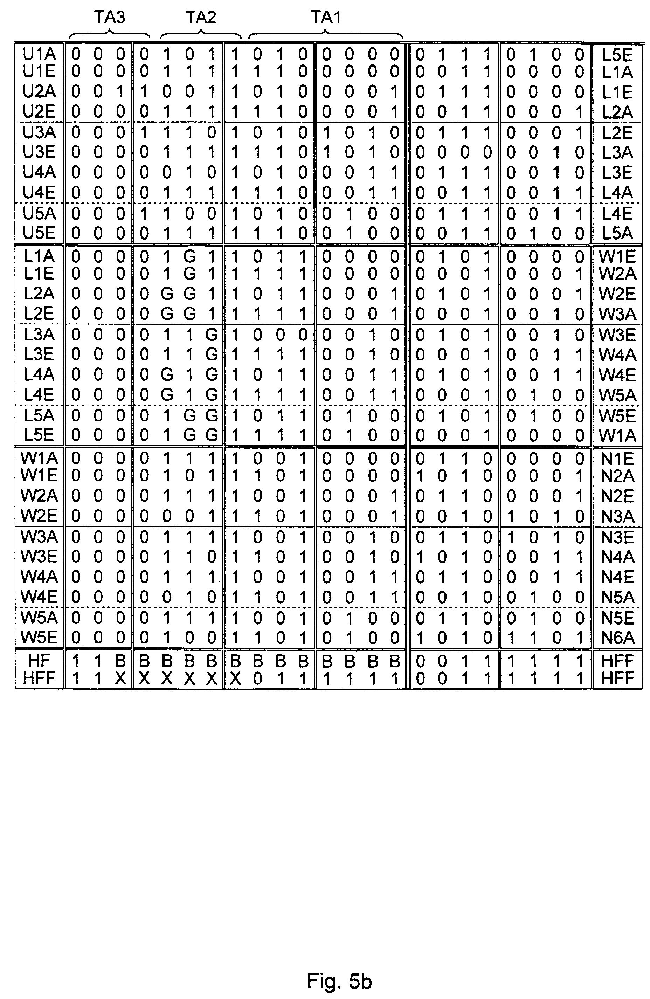

Die Figuren 4 und 5 zeigen Schrittfolge-Tabellen für Schrittschaltwerke eines erfindungsgemäßen Steuergerätes für ein Beispiel, bei dem fünf Lichtschranken unabhängig angesteuert und abgefragt werden. Figur 4 besteht aus den Teilfiguren 4a und 4b und zeigt die Schrittfolge-Tabelle für das erste Schrittschaltwerk 8A gemäß Figur 3, während Figur 5 (bestehend aus den Teilfiguren 5a und 5b) eine Schrittfolge-Tabelle für das zweite Schrittschaltwerk 8B darstellt. In jeder der Tabellen ist in der Spalte ST eine Bezeichnung des jeweiligen Schrittes angegeben. In den nächsten Spalten bis zu dem vertikalen Doppelstrich sind die digitalen Zustände der Eingänge A0 bis A14 dargestellt, die die Adresse der jeweils angesteuerten Speicherstelle des ROM bilden. Sie lassen sich in eine erste Teiladresse TA1, eine zweite Teiladresse TA2 und eine dritte Teiladresse TA3 einteilen.

In den beiden Spalten rechts von dem Doppelstrich sind die digitalen Zustände an den Ausgängen V0 bis V7 für den jeweiligen Schritt angegeben. Sie entsprechen den Inhalten der von den Eingängen A0 bis A14 angesteuerten Speicherstellen, die bei der Herstellung der Elektronikeinheit einprogrammiert werden. Die Spalte ZST gibt den Zielschritt an, der als nächster Schritt des ROM-Schrittschaltwerkes angesteuert wird.

Die horizontalen Doppellinien trennen unterschiedliche Programmabschnitte (Blöcke) des Gesamtbetriebszyklus der Schrittschaltwerke. Unterschieden werden folgende Blöcke (wobei in Klammern jeweils der zur Kennzeichnung des Blockes verwendete erste Buchstabe des Schrittes ST angegeben ist): Vorlaufblock (V), Anzugsblock (A), Normalbetriebsblock (N), Unterbrechungsblock (U), Leerblock (L), Wiederholungsblock (W), Störungsblock (S) sowie die Einzelschritte Hardwarefehler (HF) und Hardwarefolgefehler (HFF).

Die mit N gekennzeichneten Zeilen der Schrittfolge-Tabelle zeigen die Zustände der Ein- und Ausgänge im Normalbetriebsfall, d.h. für den Fall, daß die zweite Teiladresse einer funktionierenden und ununterbrochenen Lichtschranke entspricht. Die Grundfunktion ist dabei ähnlich wie bei den Figuren 1 und 2. Die Ansteuerung der Lichtsender wird durch die an den Rückführungsausgängen Q0 bis Q2 anliegenden Bit-Muster festgelegt, die sich zyklisch wiederholen. Das an der Gesamtheit der Rückführungsausgänge V0 bis V6 anliegende Bit-Muster bildet diejenige Teiladresse TA1 des nächstfolgendes Schrittes, die zusammen mit einer zweiten Teiladresse TA2 (Eingänge A7 bis A10), die einem ungestörten Zustand der jeweils angesteuerten Lichtschranke entspricht, diejenige Speicherstelle des ROM adressiert, in dem die nächste erste Teiladresse des Normalbetriebszyklus gespeichert ist. Während des Normalbetriebszyklus wird an dem Nutzsignalausgang Q7 eine Normalbetriebs-Ausgangssequenz erzeugt. Jede Abweichung von den festgelegten Bit-Mustern führt zum Verlassen des Normalbetriebszyklus.

Da in dem Normalbetriebsblock die Lichtschranken nacheinander zyklisch abgefragt werden, ist seine Länge abhängig von der Anzahl der Lichtschranken. Aus Zweckmäßigkeitsgründen wird allerdings bei fünf Lichtschranken (wie dargestellt) eine Abfrage von sechs Schritten und bei sieben Lichtschranken eine Abfrage von acht Schritten durchgeführt, wobei jeweils der letzte Schritt ein Leerschritt ist, bei dem der Inhalt des ROM so festgelegt (programmiert) ist, daß durch die Lichtschrankeneingänge A7 bis A10 kein Störsignal ausgelöst wird.

Die Erfindung zeichnet sich gegenüber der einfachen Version der Figuren 1 und 2 durch eine Reihe von Besonderheiten aus, durch die im Zusammenwirken der beiden Schrittschaltwerke auf einfache Weise ein extrem hoher Sicherheitsstandard erreicht wird.

Eine erste Besonderheit besteht darin, daß die Zahl der Signalrückführungen erheblich höher ist als zur Ansteuerung der Lichtschranken notwendig. Neben den drei zur Ansteuerung von acht Lichtschranken notwendigen Rückführungsausgängen Q0 bis Q2 sind vier weitere Ausgänge des Schrittschaltwerkes auf dessen Eingang rückgeführt. Einer dieser Rückführungsausgänge, der Ausgang Q6, dient (wie bei der EF 0 371 317) als Senderaktivierungseingang. Die Bit-Muster an den Eingängen A0 bis A2 wiederholen sich jeweils in zwei aufeinanderfolgenden Schritten, so daß jede Lichtschranke zweimal hintereinander angesteuert wird. Sie ist dabei jedoch nur bei jeweils einem Schritt in Betrieb, nämlich dann, wenn das an dem Senderaktivierungseingang A6 anliegende Signal S ein H-Signal ist. In der Spalte ST sind die Schritte, bei denen der Lichtsender in Betrieb ist, an der letzten Stelle mit "E" bezeichnet, während die Schritte, bei denen der Lichtsender ausgeschaltet ist, mit "A" bezeichnet sind. Die mittlere Stelle der Schrittbezeichnung gibt die jeweils eingeschaltete Lichtschranke an. Beispielsweise bedeutet also N1E einen Schritt, bei dem im Normalbetriebszyklus die erste Lichtschranke eingeschaltet ist. Mit Hilfe des Signals S können, ebenso wie bei der EP 0 371 317, Fehlfunktionen der Lichtschranken erkannt werden.

Drei weitere Signalrückführungen der Schrittschaltwerke 8A und 8B beziehen sich auf zusätzliche Ausgänge Q3 bis Q5 bzw. Eingänge A3 bis A5. Die weiteren Signalrückführungen ermöglichen die Ansteuerung der weiteren Blöcke mit den dadurch realisierten Zusatzfunktionen.

Eine zweite Besonderheit besteht darin, daß die Gesamtadresse des ROM nicht nur durch die Rückführungseingänge (Erste Teiladresse TA1) und die Empfängersignaleingänge (Zweite Teiladresse TA2) bestimmt ist, sondern eine dritte Gruppe von Eingängen A11 bis A14 vorhanden ist, die eine dritte Teiladresse beider Schrittschaltwerke bildet. Diese dritte Teiladresse läßt sich wiederum in zwei Teilgruppen unterteilen.
a) Zwei der Eingänge ermöglichen zusätzliche Überwachungsfunktionen und werden deswegen als Überwachungseingänge bezeichnet. Einer davon ist der Rückmeldungseingang A11, der dazu dient, die Schaltelemente der Verknüpfungsschaltung auf Kurzschluß zu überwachen. Der zweite ist der Partnerüberwachungseingang A12, der zur Überwachung der Funktion des jeweils anderen Schrittschaltwerkes mit dessen Nutzsignalausgang verbunden ist. Die Überwachungsfunktion basiert darauf, daß jede Abweichung der digitalen Zustände an diesen beiden Eingängen von der bei der Programmierung der Schrittschaltwerke festgelegten Schrittfolge dazu führt, daß der Normalbetriebszyklus verlassen und ein Sicherheitssignal ausgelöst wird. Wenn beispielsweise das andere Schrittschaltwerk nicht synchron läuft, führt dies dazu, daß die logischen Zustände 0 und 1 (L- und H-Signale) nicht mehr bei den Schritten auftauchen, die in der Schrittfolge-Tabelle vorgesehen sind.
b) Die mit manuell einstellbaren Schaltern verbundenen Einstelleingänge A13 und A14 dienen zur Einstellung des Steuergerätes auf eine unterschiedliche Anzahl von Lichtschranken. Im dargestellten Fall können mittels zwei Eingängen 2², d.h. vier unterschiedliche Zustände, nämlich zur Ansteuerung von fünf, sechs, sieben und acht Lichtschranken, eingestellt werden. Für jede der Bit-Kombinationen ist der Inhalt der Speicherstellen des ROM jeweils so festgelegt, daß eine auf die jeweilige Lichtschrankenzahl abgestimmte Schrittfolge abläuft.

Eine dritte Gruppe von Besonderheiten bezieht sich auf die Folgen der digitalen Zustände der Normalbetriebs-Ausgangsseguenzen der beiden Schrittschaltwerke 8A und 8B. Sie sind vorzugsweise unregelmäßig, d.h. innerhalb des Normalbetriebszyklus wechseln die H- und L-Zustände nicht periodisch regelmäßig, sondern bilden eine Impulsfolge, bei der die H-Zustände und/oder die L-Zustände innerhalb der Folge unterschiedlich lang sind. Im Gegensatz zu der EP 0 371 317 wird nicht bei jeder erfolgreichen Lichtschrankenabfrage ein AT-Signal erzeugt. Bevorzugt unterscheiden sich die Folgen der digitalen Zustände der Ausgangssequenzen beider Schrittschaltwerke voneinander. Der Sinn dieser Maßnahmen wird durch die nachfolgenden Erläuterungen anhand von Figur 6 deutlich.

Figur 6 besteht aus den Teilfiguren 6a bis 6c. In der Kopfzeile sind jeweils Schrittnummern ST angegeben. Am Ende der Teilfiguren ist der jeweils nächste Schritt mit Pfeil angegeben. Die nächsten zwei Zeilen zeigen die Folgen der digitalen Zustände der Nutzsignale AT1 und AT2 während der angegebenen Blöcke, also Figur 6a für den Block V, Figur 6b für den Block A, Figur 6c für den Block N. Die weiteren Zeilen zeigen die Folgen der digitalen Zustände an dem Ausgang Q3 des Schrittschaltwerkes 8B (Z1B), an dem Ausgang 26a des Monoflopps 26, an dem Ausgang 27a des Monoflopps 27 und an den Eingängen A12 beider ROM (RM).

Die Ausgangssignale AT1 bzw. AT2 triggern die Monoflopps 26 bzw. 27. Sie erzeugen dabei jeweils einen Ausgangsimpuls MM5 bzw. MM6 von vorbestimmter Dauer. Dabei ist die Impulsdauer des Monoflopps 26 mit Hilfe des Signals Z1B derartig einstellbar, daß die Impulsdauer verlängert ist, wenn Z1B auf H steht. Bei der dargestellten Ausführungsform ist die Impulsdauer des Monoflopps, abhängig von der Einschaltdauer des Signals Z1B, in zwei Stufen erhöhbar, nämlich von einem Grundwert (beispielsweise 0,48 Sekunden) auf einen ersten erhöhten Wert (beispielsweise 0,69 Sekunden), wenn Z1B maximal für die Dauer eines AT1-Impulses anliegt und auf einen zweiten erhöhten Wert (beispielsweise 1,02 Sekunden), wenn Z1B länger anliegt. Auch eine Impulsdauerverlängerung in drei oder mehr Stufen ist in entsprechender Weise möglich. Die Ausgangssignale AT1 und AT2 sind nur während eines Bruchteils (in der Praxis jeweils weniger als 35%) des Normalbetriebszyklus auf H.

Das Signal RM entspricht dem Stromfluß durch die Transistoren T1 und T2. Nur wenn beide Transistoren an ihrer Basis angesteuert werden, fließt der Spulenstrom durch die Relais-Einheit 20. Figur 6c zeigt, daß diese Bedingung (RM gleich H) nur für einen Bruchteil von deutlich weniger als 50% der gesamten Dauer des Normalbetriebszyklus erfüllt ist. Die mittlere Speisespannung der Relais-Einheit 20 beträgt demzufolge nur einen entsprechenden Bruchteil der gesamten Versorgungsspannung. Diese Spannung ist so bemessen, daß sie der Haltespannung der Relais in der Relais-Einheit 20 entspricht. Die Relais werden demzufolge nur mit ihrer Haltespannung betrieben und fallen im Störfall sehr rasch ab.

Die Normalbetriebs-Ausgangssequenzen der Signale AT1 und AT2 sind bevorzugt so bestimmt, daß jeder der Transistoren T1 und T2 in dem Normalbetriebszyklus mindestens einmal isoliert (d.h. ohne gleichzeitige Ansteuerung des anderen Transistors) angesteuert wird. Wenn der jeweils andere Transistor ordnungsgemäß funktioniert und demzufolge sperrt, ist das Rückmeldungssignal RM auf L und der Normalbetriebszyklus wird fortgesetzt. Wenn hingegen einer der Transistoren einen Kurzschlußschaden hat, führt die isolierte Ansteuerung des anderen Transistors zu einem H-Signal an den Rückmeldungseingängen A11 und damit zu einer Abweichung von der vorbestimmten Schrittfolge des Normalbetriebszyklus und zur Erzeugung eines Sicherheitssignals. Auch eine unkontrollierte Änderung ("wegdriften") der Impulsdauer der Monoflopps 26 und 27 oder der Ein-Aus-Zeiten des Taktgenerators 13 führt zu einer Abweichung von dem vorbestimmten Bit-Muster des Normalbetriebszyklus und somit zur Erzeugung eines Sicherheitssignals.

Nach dem Einschalten der Steuereinheit wird zunächst der Vorlaufblock und der Anzugsblock durchlaufen. Die in Figuren 4 und 5 dargestellte Schrittfolge gilt für den Fall, daß während dieser Blöcke keine Fehler auftreten.

In dem Vorlaufblock wird überprüft, ob die Lichtschranken funktionsfähig sind (d.h. alle Elemente der Lichtschranke funktionieren und der Lichtweg frei ist). Er entspricht (ähnlich wie bei der EP 0 371 317) weitgehend einem Normalbetriebsblock, wobei jedoch an den Nutzsignalausgängen eine Vorlauf-Ausgangssequenz erzeugt wird, die noch nicht zu dem Betriebssignal der Elektronikeinheit führt.

Eine vorteilhafte Neuerung gegenüber der EP 0 371 317 besteht darin, daß die Anzahl der angeschlossenen Lichtschranken geprüft wird. Eine Fehleinstellung der DIP-Schalter 17a, 17b wird in dem Vorlauf festgestellt, wenn die tatsächliche Anzahl der angeschlossenen Lichtschranken nicht mit der eingestellten Anzahl übereinstimmt.

Eine weitere Besonderheit besteht darin, daß der Nutzsignalausgang nicht ständig auf L steht, sondern in mindestens einem Schritt auf H springt, wobei aber, abgesehen von dem letzten Doppelschritt des Vorlaufblocks, ausgeschlossen ist, daß die Nutzsignalausgänge Q7 beider Schrittschaltwerke gleichzeitig auf H stehen. Dies erlaubt eine Kurzschlußprüfung der Transistoren T1 und T2 (wie oben beschrieben) schon während des Vorlaufs.

Während des Anzugsblockes findet im wesentlichen die gleiche Lichtschrankenabfrage wie bei dem Normalbetriebsblock statt, wobei jedoch der Anzugsblock im Hinblick auf die zum Anziehen der Relais in der Relaiseinheit 20 erforderlichen Zeit unabhängig von der Anzahl der Lichtschranken stets die gleiche Länge hat.

Der Anzugsblock dient dazu, die Spulen 21a, 21b der Relais in der Relaiseinheit 20 kurzzeitig mit einer im Vergleich zu dem Normalbetrieb deutlich erhöhten Anzugsspannung zu beaufschlagen, um ein schnelles Anziehen der Relais zu erreichen. Deshalb haben die Signale AT1 und AT2 an den Nutzsignalausgängen Q7 bei jeder "guten" Lichtschrankenabfrage (Lichtschranke funktioniert und ist frei) ein H-Signal. Außerdem wird mit Hilfe des Signals Z1B die Laufzeit des Monoflopps 26 verlängert. Dies führt dazu, daß die in Figur 6b dargestellten Ausgangssignale MM5 und MM6 während des gesamten Anzugsblocks auf H sind.

Infolgedessen ist auch RM ständig auf H, so daß die volle Versorgungsspannung an den Relaisspulen der Relaiseinheit 20 anliegt.

In einem praktischen Beispiel wird mit einer Versorgungsspannung von 24 Volt gearbeitet, die während des Anzugsblocks zu einem sehr schnellen Anzug eines Relaistyps führt, dessen Spulen für eine Nennspannung von 12 Volt ausgelegt sind. Während des Normalbetriebsblockes wird die Versorgungsspannung der Spulen auf eine Haltespannung von beispielsweise 4 Volt reduziert, so daß die Relais der Relaiseinheit 20 im Störfall sehr rasch abfallen.

Wie bereits mehrfach erwähnt, führt jede Abweichung von der vorgegebenen Schrittfolge innerhalb der Blöcke V, A und N dazu, daß am Ausgang der Schrittschaltwerke 8A und 8B ein Störfall-Ausgangssignal ansteht und die Sicherheitssignal-Erzeugungseinrichtung 10 von dem Normalbetriebssignal auf ein Sicherheitssignal wechselt, insbesondere die in der Relaiseinheit 20 enthaltenen Relais abfallen und über ihre Arbeitskontakte und eine in der Regel maschinenseitig vorhandene Nachfolgeschaltung die von dem Steuergerät überwachte Maschine stillsetzt.

Das Verhalten des Schrittschaltwerkes bei einem Fehler während der EIN-Abfrage ("schlechte" Abfrage) zeigt der Block U. Er entspricht dem Block N, wobei jedoch an den Lichtschrankeneingängen A7 bis A10 ein Signal ansteht, das einer unterbrochenen Lichtschranke entspricht. Während im Falle eines N-Schrittes die in der rechten Spalte angegebene Zieladresse ZST zur Fortsetzung des Zyklus führt, bewirkt im Falle eines U-Schrittes die rechts angegebene Zieladresse den Übergang in den L-Block.

Der Leerblock L ist aus praktisch-technischen Gründen im Hinblick auf die Funktionsweise des Taktgenerators 13 erforderlich. Der Taktgenerator wird in Abhängigkeit von dem Signal S gesteuert, das ihm von dem Taktausgang Q6 des Schrittschaltwerkes 8A zugeführt wird. Das Signal S wechselt nach jeder Lichtschranken-Abfrage den Pegel. Um die Wiederholung einer schlechten EIN-Abfrage zu ermöglichen, muß erst eine AUS-Abfrage durchgeführt werden. Da diese AUS-Abfrage für die Lichtschrankenüberwachung nicht benötigt wird, wird der Schritt als Leerschritt bezeichnet. In dem L-Block bedeutet G, daß die damit bezeichneten Eingänge entweder alle den Wert 1 oder alle den Wert 0 haben. Der Leerschritt führt in der dargestellten Art und Weise zur Wiederholung der schlechten EIN-Abfrage in dem Wiederholungsblock W.

Die Schritte des Wiederholungsblockes W stimmen mit den entsprechenden Normalbetriebsschritten identisch überein, d.h. die gleiche Lichtschranke, bei der zuvor eine Störung aufgetreten war (sowohl Unterbrechungsfehler bei EIN-Abfragen als auch Fehler bei AUS-Abfragen) wird nochmals abgefragt. Dadurch sollen Fehlabschaltungen vermieden werden, die insbesondere durch elektromagnetische Einflüsse oder durch Fremdlichtstörungen verursacht werden können.

Da der Leerschritt und der Wiederholschritt jeweils nur für die Lichtschranke durchgeführt werden, bei der eine Störung aufgetreten war, ist die hierfür benötigte Zeit sehr kurz. In einem praktischen Fall, bei dem jede EIN-Abfrage ca. 0,6 msec und jede AUS-Abfrage ca. 0,4 msec dauert, führt die nochmalige Abfrage zu einer zeitlichen Verzögerung von max. 1 msec. Dies wäre im Hinblick auf die Vermeidung von Fehlabschaltungen hinzunehmen. Selbst diese geringfügige Verzögerung wird bei der dargestellten bevorzugten Ausführungsform jedoch dadurch ausgeglichen, daß in dem Fall eines wiederum schlechten Wiederholschrittes das Signal an dem Nutzsignalausgang während der Blöcke U und L ein L-Signal bleibt, so daß die Relais der Relaiseinheit 20 schon abzufallen beginnen. Nur für den Fall eines guten Wiederholschrittes (wie in den Figuren 4b und 5b dargestellt) liegt am Ausgang ein H-Signal an und das unerwünschte Abfallen der Relais wird verhindert. Infolgedessen wird durch den Wiederholschritt eine Erhöhung der Sicherheit gegen Fehlabschaltungen erreicht, ohne daß die Ansprechzeit verlängert wird. Wenn sich bei dem Wiederholschritt die Störung nicht bestätigt, ist die Zieladresse der entsprechende nächste Schritt des Normalbetriebsblockes, d.h. die Schrittfolge springt in den Normalbetriebszyklus zurück.

Der mit dem Buchstaben S gekennzeichnete Störungsblock dient dazu, bei einer Störung während der EIN-Abfrage die unterbrochene Lichtschranke anzuzeigen. Der Buchstabe A im S-Block bedeutet alle Adressen, die bei Unterbrechung einer Lichtschranke in einem der Blöcke V, A oder W erzeugt werden. Die Anzeige der unterbrochenen Lichtschranke wird dadurch erreicht, daß das Bit-Muster an den Ausgängen Q0 bis Q2 die unterbrochene Lichtschranke ansteuert, d.h. mit dem Bit-Muster an den Eingängen A0 bis A2 identisch übereinstimmt. Demzufolge wird der Zyklus der Lichtschrankenansteuerung beendet und die gestörte Lichtschranke angesteuert. Dadurch wird die Suche und Beseitigung des Fehlers erleichtert. Das Schrittschaltwerk bleibt in dem Störungszustand stehen.

Die Sicherheitsnormen verlangen, daß auch für den Fall, daß durch eine Fehlfunktion, beispielsweise durch eine elektromagnetische Einstreuung, noch ein Taktimpuls entsteht, kein Weg zurück in den Normalbetriebszyklus führen darf. Diesem Zweck dienen die Schritte HF und HFF. HF (Hardware-Fehler) wird als Zieladresse sämtlicher Schritte des Störungsblockes S adressiert. Die gleiche Zieladresse entsteht unmittelbar nach dem Wiederholschritt, wenn eine AUS-Abfrage gestört ist, sowie bei sämtlichen Störungen des Schrittschaltwerkes 8B. In der Tabelle bezeichnet B alle Bitmuster der Eingänge, außer den zuvor angegebenen Bitmustern der Schrittfolgetabelle. Die Zieladresse des Schrittes HF ist HFF. In der Zeile HFF bezeichnet X jeden beliebigen digitalen Zustand (0 oder 1). An den Ausgängen liegt sowohl bei HF als auch bei HFF ein Bitmuster (im Beispielfall die Hexadezimal-Zahl 3F) an, bei dem kein H-Impuls am Nutzsignalausgang V7 und an dem Taktausgang V6 ausgegeben wird. Bei den Schritten HF und HFF erfolgt keine Anzeige der gestörten Lichtschranke.

Generell sollten die Speicherstellen der beiden ROM 11A und 11B, die in dem gesamten Betriebszyklus der ROM-Schrittschaltwerke 8A und 8B nicht verwendet werden, zumindest hinsichtlich der Rückführungsausgänge V0 bis V6 so bestimmt sein, daß für beliebige Zustände an den übrigen Eingängen des ROM (die keine Rückführungseingänge sind) keine Normalbetriebsausgangssequenz an den Nutzsignalausgängen Q7 erzeugt werden kann.

Wie erwähnt, erlaubt die Erfindung auf einfache Weise und ohne Änderung der Hardware die Abfrage von Sicherheitseinrichtungen mit einer unterschiedlichen Anzahl von Lichtschranken. Dabei werden die Blöcke N, U, L und W entsprechend der vorstehend erläuterten Grundsätze angepaßt. Zur Verdeutlichung sind in der Figur 6a die Impulsfolgen für sechs und sieben Lichtschranken als gestrichelte Linien eingezeichnet.

Eine Anpassung für die Ansteuerung von weniger als fünf Lichtschranken ist problemlos möglich. Die Lichtschranken werden dabei direkt (ohne die Encoder 16A und 16B) an die Eingänge A7 bis A10 der ROM 11A und 11B angelegt. Um die gleiche Schrittfolge wie bei fünf bis acht Lichtschranken verwenden zu können, ist es dabei zweckmäßig, die Lichtschranken jeweils mehrfach abzufragen.

Obwohl die dargestellte Steuereinheit nur acht Lichtschranken getrennt ansteuern kann, ist es möglich, mit den gleichen Bauteilen in den ROM-Schrittwerken 8A und 8B auch eine größere Anzahl von Lichtschranken anzusteuern. Dazu muß eingangsseitig eine zusätzliche Verdichtung erfolgen, um insgesamt mit der vorgegebenen Zahl von Eingängen des EPROM auszukommen. Wenn man statt des dargestellten einfachen Prioritätsencoders etwas aufwendigere Bauteile zur Reduzierung der Eingangssignale verwendet, ist die Anpassung an eine größere Lichtschrankenzahl problemlos möglich. Beispielsweise kann ein "intelligenter Komprimierer" auf Basis von Mikroprozessortechnik eingesetzt werden. Dies gilt insbesondere wenn die Anzahl der Lichtschranken über sechzehn hinaus erhöht wird und/oder wenn Sonderfunktionen, wie die kurzzeitige Abschaltung einzelner Lichtschranken zum Zwecke der Hindurchführung von Bearbeitungsteilen realisiert werden sollen. In einfacheren Fällen kann ein EPROM mit sechzehn Eingängen zur Verdichtung von sechzehn Lichtschranken auf fünf Ausgänge eingesetzt werden.

Insgesamt werden durch die Erfindung bedeutende Vorteile gegenüber dem Stand der Technik erreicht. Die EP 0 371 317 ermöglicht bereits ein sehr hohes Sicherheitsniveau mit geringem Aufwand. Selbst gegenüber dieser vorbekannten Druckschrift wird bei der Erfindung ohne nennenswerten Mehraufwand der Sicherheitsstandard nochmals erhöht und gleichzeitig die universelle Umstellbarkeit der Steuereinheit auf unterschiedliche Lichtschrankenzahlen ohne Hardware-Modifikation (lediglich durch die Änderung der Ansteuerung der Einstelleingänge) erreicht.

## Patentansprüche

1. Lichtschrankensteuergerät für mehrere Lichtschranken (2-5), die jeweils einen Lichtsender und einen Lichtempfänger aufweisen, mit einer Elektronikeinheit (15) an der die Signale der Lichtschranken (2-5) anliegen und die ein Sicherheitssignal erzeugt, wenn mindestens eine Lichtschranke unterbrochen wird, wobei
die Elektronikeinheit ein ROM-Schrittschaltwerk (8) enthält, welches ein ROM (11), einen dem ROM nachgeordneten Schrittspeicher (12) mit mindestens N bistabilen Speicherstellen und einen Taktgenerator (13), der zur Taktung des Schrittspeichers dient, aufweist,
mindestens ein Teil N der Ausgänge des ROM (11) als Rückführungsausgänge (V0-V6) an N Rückführungseingängen (D0-D6) des Schrittspeichers (12) anliegt,
die entsprechenden N Rückführungsausgänge (Q0-Q6) des Schrittspeichers (12) auf Rückführungseingänge (A0-A6) des ROM (11) zurückgeführt sind, so daß das jeweils an den Rückführungsausgängen (Q0-Q6) des Schrittspeichers (12) anliegende N-Bit-Wort einen Teil der am Eingang des ROM (11) anliegenden Adresse (erste Teiladresse) bildet und das jeweils an den Rückführungsausgängen (V0-V6) des ROM (11) anliegende N-Bit-Wort nach Taktung des Schrittspeichers (12) die nächstfolgende erste Teiladresse bildet,
mindestens ein Teil der Ausgänge des ROM-Schrittschaltwerkes (8) als Ansteuerungsausgänge (Q0-Q2) verwendet wird, um Signale zum Ansteuern der Lichtsender zu erzeugen,
ein Teil der Eingänge des ROM als Empfängereingänge (A7-A10) dient, an denen Empfängersignale anliegen, so daß sie eine zweite Teiladresse des ROM (11) bilden,
mindestens einer der Ausgänge des ROM-Schrittschaltwerkes (8) als Nutzsignalausgang (Q7) dient, der mit einer Sicherheitsignal-Erzeugungseinrichtung (10) verbunden ist,
die durch die Gesamtadresse aus erster Teiladresse und zweiter Teiladresse bestimmten Speicherstellen des ROM für den Fall, daß die zweite Teiladresse einer funktionierenden ununterbrochenen Lichtschranke entspricht (Normalbetriebsfall) eine vorbestimmte Folge von Bit-Mustern enthalten, bei der sich die an den Rückführungsausgängen (V0-V6) anliegenden N-Bit-Worte zyklisch wiederholen, so daß sich die Schrittfolge des ROM-Schrittschaltwerkes (8) innerhalb eines Normalbetriebszyklus ebenfalls zyklisch wiederholt und die Lichtschranken über die Ansteuerungsausgänge (Q0-Q2) zyklisch angesteuert werden, wobei an dem Nutzsignalausgang (Q7) des ROM-Schrittschaltwerkes eine vorbestimmte Folge von digitalen Impulsen als Normalbetriebs-Ausgangssequenz erzeugt wird und
die durch die Gesamtadresse aus erster Teiladresse und zweiter Teiladresse bestimmten Speicherstellen des ROM (11) für den Fall, daß die zweite Teiladresse nicht einer ununterbrochenen Lichtschranke entspricht (Störfall) einen von der vorbestimmten Folge von Bit-Mustern des Normalbetriebszyklus abweichenden Speicherinhalt enthalten, so daß der Normalbetriebszyklus unterbrochen und an dem Nutzsignalausgang (Q7) ein Störfall-Ausgangssignal erzeugt wird, aufgrund dessen die Sicherheitssignal-Erzeugungseinrichtung (10) das Sicherheitssignal erzeugt,
**dadurch gekennzeichnet,**
daß die Elektronikeinheit zwei ROM-Schrittschaltwerke (8A, 8B) mit jeweils einem ROM (11A, 11B) und einem nachgeordneten Schrittspeicher (12A, 12B) enthält, jedes ROM Empfängereingänge (A7-A10) aufweist, an denen Empfängersignale anliegen, die beiden ROM-Schrittschaltwerke (8A, 8B) synchron getaktet sind und die Nutzsignalausgänge (Q7) beider Schrittschaltwerke (8A, 8B) mit einer gemeinsamen Sicherheitssignal-Erzeugungseinrichtung (10) verbunden sind, die ein Sicherheitssignal erzeugt, wenn an dem Nutzsignalausgang (Q7) von mindestens einem der Schrittschaltwerke (8A, 8B) ein Störfall-Ausgangssignal erzeugt wird.

2. Lichtschrankensteuergerät nach Anspruch 1, **dadurch gekennzeichnet**, daß die Speicherinhalte der beiden ROM (11A, 11B) so bestimmt sind, daß die Folgen der digitalen Zustände der Normalbetriebs-Ausgangssequenzen beider Schrittschaltwerke (8A, 8B) unterschiedlich sind.

3. Lichtschrankensteuergerät nach einem der vorhergehenden Ansprüche, **dadurch gekennzeichnet**, daß die Folge der digitalen Zustände der Normalbetriebs-Ausgangssequenz von mindestens einem der Schrittschaltwerke (8A, 8B) unregelmäßig ist.

4. Lichtschrankensteuergerät nach einem der vorhergehenden Ansprüche, **dadurch gekennzeichnet**, daß die Sicherheitssignal-Erzeugungseinrichtung (10) eine Verknüpfungsschaltung (19) aufweist, durch die die beiden Ausgangssignale der Schrittschaltwerke (8A, 8B) im Sinne einer logischen "und"-Verknüpfung verknüpft werden.

5. Lichtschrankensteuergerät nach Anspruch 4, **dadurch gekennzeichnet**, daß die Sicherheitssignal-Erzeugungseinrichtung (10) als Verknüpfungsschaltung (19) zwei in Reihe geschaltete Schaltelemente (T1, T2), insbesondere Schalttransistoren, aufweist.

6. Lichtschrankensteuergeräte nach Anspruch 5, **dadurch gekennzeichnet**, daß die Dauer der Ansteuerung der Schaltelemente (T1, T2) von der Folge der digitalen Zustände der Normalbetriebs-Ausgangssequenz beeinflußt wird.

7. Lichtschrankensteuergerät nach einem der Ansprüche 5 oder 6, **dadurch gekennzeichnet**, daß die Reihenschaltung der Schaltelemente (T1, T2) mit einer Sicherung abgesichert ist, die Schaltelemente im Normalbetriebszyklus derartig angesteuert werden, daß beide Schaltelemente während einer Schließzeit von weniger als der Hälfte des Normalbetriebszyklus gleichzeitig geschlossen sind und der Grenzwert der Sicherung so gewählt ist, daß sie bei Überschreiten dieser maximalen Schließzeit anspricht.

8. Lichtschrankensteuergerät nach einem der vorhergehenden Ansprüche, **dadurch gekennzeichnet**, daß die Sicherheitssignal-Erzeugungseinrichtung (10) einen monostabilen Multivibrator (26) aufweist, mit dessen Eingang ein Nutzsignalausgang (Q7) eines Schrittschaltwerkes (8) so verbunden ist, daß er von Flanken der digitalen Zustände von dessen Normalbetriebs-Ausgangssequenz getriggert wird, um ausgangsseitig einen Impuls von vorbestimmter Dauer zur Weiterverarbeitung in der Sicherheitssignal-Erzeugungseinrichtung (10) zu generieren.

9. Lichtschrankensteuergerät nach Anspruch 8, **dadurch gekennzeichnet**, daß die vorbestimmte Dauer des Impulses des monostabilen Multivibrators (26, 27) in Abhängigkeit von einem Ausgangssignal (Z1B) eines Schrittschaltwerkes (8), vorzugsweise mehrstufig, einstellbar ist.

10. Lichtschrankensteuergerät nach einem der Ansprüche 8 oder 9, **dadurch gekennzeichnet**, daß die Sicherheitssignal-Erzeugungseinrichtung zwei monostabile Multivibratoren (26,27) mit vorzugsweise unterschiedlicher Impulsdauer aufweist, die mit je einem Nutzsignalausgang (Q7) der beiden Schrittschaltwerke (8A, 8B) verbunden sind.

11. Lichtschrankensteuergerät nach Anspruch 10 in Verbindung mit Anspruch 5, **dadurch gekennzeichnet**, daß die Ausgänge der monostabilen Multivibratoren (26, 27) mit den Eingängen der Schaltelemente (T1, T2) zu deren Ansteuerung verbunden sind.

12. Lichtschrankensteuergerät nach einem der vorhergehenden Ansprüche, **dadurch gekennzeichnet**, daß die Sicherheitssignalerzeugungseinrichtung (10) mit einem als Rückmeldungseingang (A11) dienenden Eingang von mindestens einem ROM verbunden ist, um wahrend des Normalbetriebszyklus eine Überprüfung ihrer Funktion zu ermöglichen.

13. Lichtschrankensteuergerät nach einem der vorhergehenden Ansprüche, **dadurch gekennzeichnet**, daß je ein Eingang der beiden ROM (11A, 11B) als Partnerüberwachungseingang (A12) dient, der zur Überprüfung der Funktion des jeweils anderen Schrittschaltwerkes (8A, 8B) mit dessen Nutzsignalausgang (Q7) verbunden ist.

14. Lichtschrankensteuergerät nach einem der vorhergehenden Ansprüche, **dadurch gekennzeichnet**, daß ein Teil der Eingänge der ROM (11A, 11B) als Einstelheingänge (A13, A14) dient, an die individuell einstellbare Schalter (17A, 17B) angeschlossen sind, um das Lichtschrankensteuergerät auf verschiedene Betriebszustände einzustellen, die sich hinsichtlich der Anzahl der Lichtschranken unterscheiden.

15. Lichtschrankensteuergerät nach einem der vorhergehenden Ansprüche, **dadurch gekennzeichnet**, daß der Speicherinhalt der beiden ROM (11A, 11B) so vorbestimmt ist, daß bei Unterbrechung einer Lichtschranke ein Wiederholschritt durchgeführt wird, bei dem die gleiche Lichtschranke nochmals angesteuert wird.

16. Lichtschrankensteuergerät nach einem der vorhergehenden Ansprüche, **dadurch gekennzeichnet**, daß die Speicherinhalte der beiden ROM (11A, 11B) so vorbestimmt sind, daß die vorbestimmte Schrittfolge der beiden Schrittschaltwerke (8A, 8B) einen Anzugsblock einschließt, in dem an dem Nutzsignalausgang eine Folge von digitalen Impulsen als Anzugsblock-Ausgangssequenz erzeugt wird, wobei die Impulsdichte in der Anzugsblock-Ausgangssequenz höher als in der Normalbetriebs-Ausgangssequenz ist.

17. Lichtschrankensteuergerät nach einem der vorhergehenden Ansprüche, **dadurch gekennzeichnet**, daß die Speicherstellen der beiden ROM (11A, 11B), die in dem gesamten Betriebszyklus des jeweiligen ROM-Schrittschaltwerkes nicht verwendet werden, hinsichtlich der Rückführungsausgänge V0 bis V6 so bestimmt sind, daß für beliebige Zustände an den übrigen Eingängen des ROM keine Normalbetriebsausgangssequenz erzeugt werden kann.
